# EUROPEAN PATENT SPECIFICATION

(11) **EP 4 215 290 B1**
(45) Date of publication and mention of the grant of the patent: **04.11.2026**
(21) Application number: 21869407.3
(22) Date of filing: 15.09.2021
(51) Int. Cl.: B09B 3/30, B09B 3/40, H05K 13/04

(54) **BOARD PEELING DEVICE AND BOARD PEELING SYSTEM**
PLATTENSCHÄLVORRICHTUNG UND PLATTENSCHÄLSYSTEM
DISPOSITIF DE PELAGE DE CARTE ET SYSTÈME DE PELAGE DE CARTE

(30) Priority: 17.09.2020 JP 2020156010
(43) Date of publication of application: 26.07.2023
(73) Proprietor: Astec Irie Co., Ltd., Kitakyushu-shi, Fukuoka 805-8507 (JP)
(72) Inventor: YOSHIMURA, Taichi, Nakama-shi Fukuoka 809-0038 (JP); INOUE, Nobuhiro, Kitakyushu-shi Fukuoka 805-8507 (JP); KOMORI, Yuji, Kitakyushu-shi Fukuoka 805-8507 (JP); KONISHI, Masakazu, Kitakyushu-shi Fukuoka 805-8507 (JP); TAKAHASHI, Hiroyuki, Kitakyushu-shi Fukuoka 805-8507 (JP); HALADA, Kohmei, Tsukuba-shi Ibaraki 305-0035 (JP)
(74) Representative: Müller-Boré & Partner Patentanwälte PartG mbB
(86) International application number: PCT/JP2021/034001
(87) International publication number: WO 2022/059721

(56) References cited:
- WO-A1-2013/111206
- CN-U- 206 981 409
- JP-A- 2000 005 612
- JP-A- 2001 113 259
- JP-A- 2001 308 515
- JP-A- 2008 043 936
- JP-A- H08 139 446

## Description

### TECHNICAL FIELD

This invention relates to an apparatus and a system for stripping or detaching electronic components mounted on a mounting substrate.

### BACKGROUND ART

Electrical and electronic products such as televisions, personal computers, and smart phones have a built-in mounting substrate. Many electronic components such as IC (integrated circuit) chips, IC packages, capacitors, and resistors are mounted on the mounting substrate. Since precious metals and rare metals such as gold, silver, copper, and palladium are used in these electronic components, these precious metals, rare metals, etc. are recovered from the electronic components mounted on used mounting substrates. In the recovery of precious metals, rare metals, etc., it is desirable to increase the ratio of certain precious metals, rare metals, etc. (e.g., gold) as much as possible by assorting the types of the electronic components. In other words, it is necessary to detach the various electronic components mounted on the mounting substrate and sort them by type of the electronic components.

JP 2001 308515 A describes a device and a method for removing parts from substrate by which parts mounted on a substrate can be removed from the substrate.

CN 206 981 409 U describes an electronic waste recycling device including a press machine base, a magnetic conveyor belt and a peeling separator.

### Patent Literature

Japanese Unexamined Patent Application Publication No. 2004-1976

### SUMMARY OF THE INVENTION

### Problems to be Resolved by the Invention

Devices, apparatuses and jigs for individually stripping or detaching or peeling electronic components or parts mounted on a mounting substrate have been proposed. For example, Patent Document 1 discloses a stripping tool which consists of a link arm with a stripping claw at the tip. This stripping tool strips off electronic components mounted on a mounting substrate individually with the stripping claw. Accordingly, since only desired electronic components can be selected and separated from the mounting substrate, specific electronic components can be sorted. However, since stripping off only specific electronic components from the mounting substrate on which many electronic components are mounted has poor workability and is inefficient, it is not profitable for recovering used electronic components. Since the electronic components are adhered to the mounting substrate with solder or the like, the mounting substrate is heat-treated at a temperature at which the solder melts or softens to weaken the adhesion of the electronic components to the mounting substrate. After that, it is also implemented that the electronic components are removed or detached from the mounting substrate by dropping the mounting substrate. However, this method is inefficient for recovering electronic components because many electronic components cannot be removed or detached from the mounting substrate.

### Solution to Problem

The present invention relates to an apparatus and a system for stripping or detaching an electronic component mounted on a mounting substrate while rotating and tracing a screw blade on the surface of the mounting substrate.

The present invention is defined by the independent claim. Preferred examples are defined in the dependent claims.

### Advantageous Effect of the Invention

In the apparatus for detaching substrate components of the present invention, since the screw blade comes into contact with the electronic components and the like mounted on the mounting substrate and the electronic components and the like are stripped or detached from the substrate, the electronic components can be efficiently and reliably separated or detached from the mounting substrate. Since the electronic components can be separated or detached by rolling up the electronic components while the screw blade rotates, damages to the electronic components can be reduced. Since a plurality of screw blades are attached to the rotating shaft and the winding direction of them is opposite in both sides of the rotating shaft, the force exerted on the screw blade roller is canceled out when the electronic components and other components are detached. Therefore, since the load exerted on the screw blade roller and motor can be reduced, the life of the screw blade roller and motor can be extended. Screw blade rollers can also be arranged at multiple stages in the apparatus for detaching substrate components. Since the mounting substrates are sequentially passed through the screw blade rollers arranged at multiple stages, and the electronic components are detached or stripped off according to the size of the electronic components, the load exerted on the screw blades in each stage can be reduced, and the electronic components can be reliably detached or stripped off. The mounting substrate heating apparatus can be also placed in the preceding stage of the apparatus for detaching substrate components of the present invention. Since the apparatus for detaching substrate components is used to continuously process the mounting substrate after the mounting substrate is heated by the substrate heating apparatus to soften and melt the solder and the like that adhere the electronic components to the mounting substrate, the electronic components and the like can be easily separated or detached from the mounting substrate. In the mounting substrate heating apparatus, the projecting plate is attached to the belt conveyor. Since the mounting substrate is placed on the projecting plate and heated while being transported in a tilted and non-overlapping state, a large number of mounting substrates can be efficiently and reliably heated in the mounting substrate heating apparatus. Since the system for detaching substrate components of the present invention, which combines the mounting substrate heating apparatus and the apparatus for detaching substrate components, can continuously handle the process from heating to detaching and can be automated, a large amount of electronic components and the like can be detached or stripped off from the mounting substrates at low cost, and the waste electronic components and the like can be recovered.

### BRIEF DESCRIPTION OF THE DAWINGS

FIG.1 is a diagram showing a system for detaching substrate components in which a substrate heating apparatus is coupled to an apparatus for detaching substrate components of the present invention.
FIG.2 is a diagram showing how the substrate enters the apparatus for detaching substrate components.
FIG.3 is a diagram showing an example of a screw blade roller used in the apparatus for detaching substrate components.
FIG.4 is a diagram showing the state of the mounting substrate and the screw blade rollers inside the apparatus for detaching substrate components.
FIG.5 is a diagram showing a suspension system for a screw blade roller.
FIG.6 is a diagram showing the function of the multiple stage screw blades in the apparatus for detaching substrate components.
FIG.7 is a diagram showing a second embodiment of the detaching blades.
FIG.8 is a diagram showing the movement of the inclined blade roller.
FIG.9 is a top view of the apparatus for detaching substrate components viewed from the direction that the mounting substrate enters.
FIG.10 is a diagram showing a method of transporting the mounting substrate in the substrate heating apparatus.
FIG.11 is a diagram showing a state in which the mounting substrate is placed on the projecting plate,

### EMBODIMENTS FOR CARRYING OUT THE INVENTION

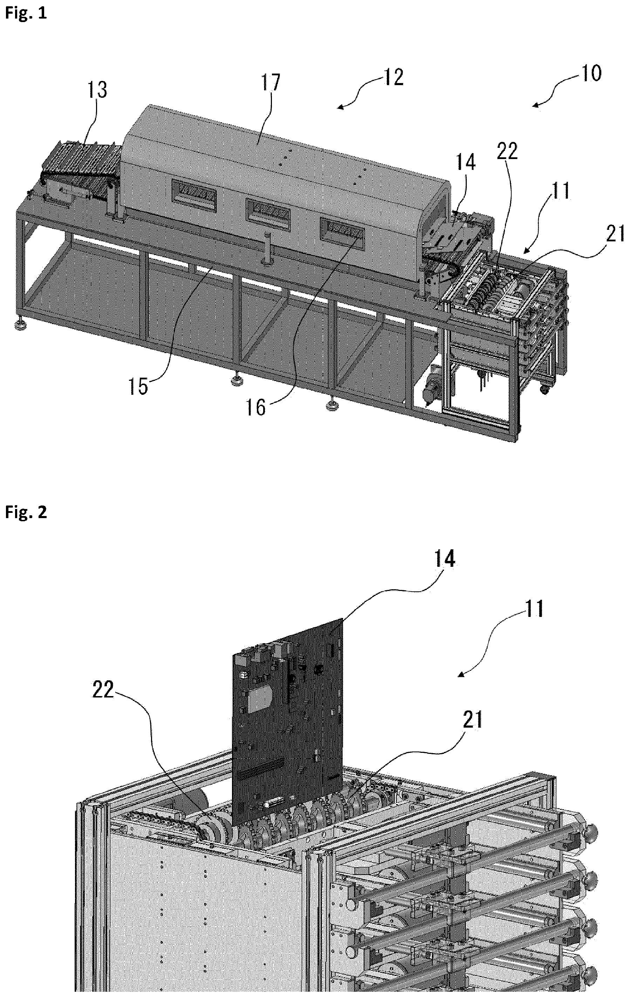

FIG.1 is a diagram showing a system for detaching substrate components 10 in which a substrate heating apparatus 12 is coupled to an apparatus for detaching substrate components 11 of the present invention. Detaching substrate components means removing or detaching or stripping components and the like mounted on the (mounting) substrate. This system for detaching substrate components can be called an apparatus for detaching substrate components with a (mounting substrate or substrate) heating apparatus or (electronic) components detaching system. In the substrate heating apparatus 12, a heating furnace 17 and a conveyor belt (or also referred to as a conveyor caterpillar) 13 are placed on a trestle 15. The inside of the heating furnace 17 can be viewed through an observation window 16. The conveyor belt 13 passes through the heating furnace 17 of the substrate heating apparatus 12. After a substrate 14 mounted with many electronic components and the like that is placed on a conveyor belt 13 is heated in the heating furnace 17, the substrate 14 comes out from the substrate heating apparatus 12 and is taken or inserted one by one into the apparatus for detaching substrate components 11.

FIG.2 is a diagram showing how the substrate 14 enters the apparatus for detaching substrate components 11. The substrate 14 enters and descends between a blade roller 21 and a feed roller 22 arranged in the apparatus for detaching substrate components 11. The substrate surface on which many components are mounted (referred to as a front surface of the substrate) is made to face the blade roller 21. The surface opposite to the front surface of the substrate (referred to as a rear or back surface of the substrate) is made to face a feed roller 22. The blade roller is a rotary roller which a detaching blade such as a screw blade and a gear blade and the like for removing or detaching or stripping parts or components from the substrate is attached to. The heating furnace 17 is, for example, a steam heating furnace using a superheated steam, an infrared heating furnace, or a resistance heating furnace. It heats the substrate(s) 14 at a temperature of about 200°C to about 500°C. Many electronic components and the like are mounted on the substrate 14. Since these electronic components and the like are adhered to the substrate with a solder, an adhesive, or the like, the heating of the substrate(s) in the (substrate) heating apparatus 12 softens or melts solder, adhesive, or the like, considerably reducing the adhesion of the electronic components and the like. In recent years, Pb(lead) -free materials have been used as solder. For example, since Sn-Cu-Ag-based solder has a melting point of about 210°C to about 400°C, the substrate is heated at temperature around the melting point. Immediately after the heat treatment of the substrate 14, the substrate 14 is passed into the apparatus for detaching substrate components 11 of the present invention, and the electronic components and the like mounted on the substrate 14 are detached or stripped off.

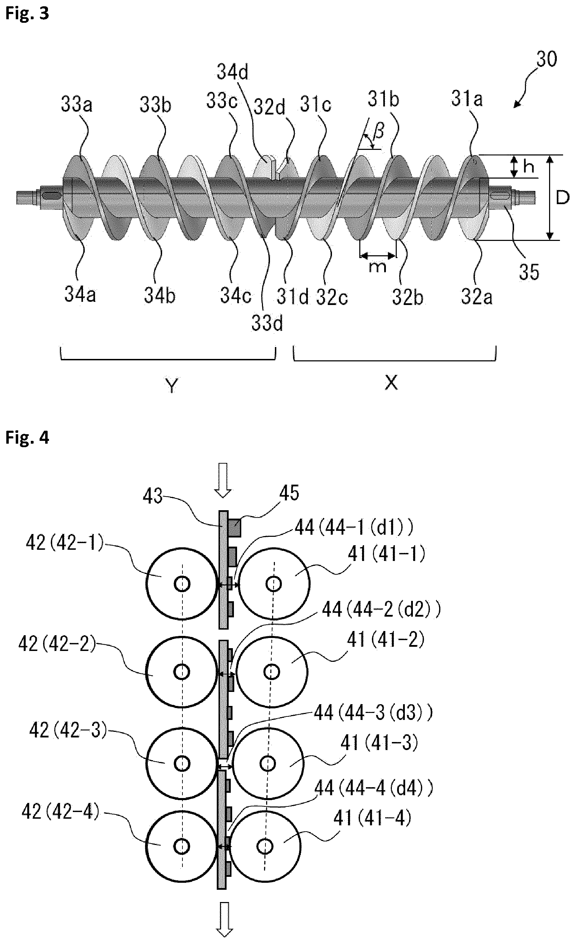

FIG.3 is a diagram showing an example of a screw blade roller used in the apparatus for detaching substrate components. The screw blade roller 30 has screw blades 31, 32, 33 and 34 attached to a rotary shaft 35. The screw blades are helical (or spiral or screw) shaped blades attached to the shaft (rotary shaft) in such a way that they wind around the shaft in a helical shape. Since the screw blades come into contact with the components (or parts) such as electronic components mounted on the mounting substrate while rotating to detach those components from the mounting substrate, they are made of harder, tougher, and less-wearing materials than the components (or parts). Examples they include steel materials such as SS400 and stainless materials such as SUS304, but are not limited to them.

In the screw blade roller 30, it is desirable that the area (or region) (X + Y) where the screw blade is attached should be equal to or larger than the full width of the mounting substrate on which the components and parts to be detached are mounted, so that all the components and parts mounted on the mounting substrate can be detached or stripped off. If the size (width) of the mounting substrate is 30 cm, (X+Y) is preferably about 29 cm to 30 cm or more. In FIG.3, two screw blades are attached at equal intervals to the rotary shaft so as to wind around the rotary shaft 35. In addition, the winding directions of the screw blades are opposite between the half area X and the remaining half area Y in the width of the rotary shaft 35 shown in FIG.3.

That is, in the X region (or area), two screw blades 31 and 32 are wound around and attached to the rotary shaft 35 at equal intervals. In the Y region (or area), two screw blades 33 and 34 are attached to the rotary shaft 35 at equal intervals while being wound around the rotary shaft 35 in the opposite direction to the X region. In the screw blades 31 (a, b, c, d), the screw blade 31a is continuously connected to the screw blades 31b, 31c and 31d in sequence. In the screw blades 32 (a, b, c, d), the blade 32a is continuously connected to the screw blades 32b, 32c and 32d in sequence. In the screw blades 33 (a, b, c, d), the screw blade 33a is continuously connected to the screw blades 33b, 33c and 32d in sequence. In the screw blades 34 (a, b, c, d), the screw blade 34a is continuously connected to the screw blades 34b, 34c and 34d in sequence. At the boundary between the X region and the Y region, it is desirable that the screw blades with opposite winding direction almost come into contact with each other so as not to create a gap. If there is the gap, components and parts in the gap may not be sufficiently detached or stripped off. Alternatively, there may be a problem that the detached components and parts enter the gap and cannot be removed. Accordingly, it is desirable that the screw blade 31d is substantially in contact with the screw blade 33d and that the blade 32d is substantially in contact with the blade 34d.

Since the mounting substrate comes out through the heating furnace and immediately enters the apparatus for detaching substrate components, while the mounting substrate stays in the apparatus for detaching substrate components, the adhesive such as solder used in the electronic components mounted on the mounting substrate is in a softened or melted state. Accordingly, when the screw blades come into contact with the electronic components mounted on the mounting substrate, the electronic component are easily separated or detached from the mounting substrate. If circular blades are used, since the blades rotate at the same position, the force acts only in one direction (i.e., perpendicular direction to the rotary shaft). Therefore, there is a high possibility that the electronic components that cannot be detached once cannot be detached no matter how many times the circular blades rotate. In the case of the screw blades, forces act in oblique and three-dimensional directions, and the screw blades come int contact with the components, etc. mounted on the mounting substrate at equal distances in all areas in the direction of the rotary axis. Therefore, the detaching or stripping efficiency is very high because almost all components are detached or stripped under the same force. Furthermore, since the electronic components are detached or stripped off so that they are wound up, the detached or stripped electronic components do not stay on the screw blades. Also, since the winding directions of the screw blades are reversed between the X region and the Y region, the detaching forces when detaching the electronic components are opposite in the X region and the Y region. Therefore, since the forces applied to the rotary shaft are offset or canceled, excessive forces are not applied to the screw blades. As a result, excessive loads are not applied to a motor that rotates the rotary shaft, and damages to the rotary shaft and screw blades are less likely to occur.

Without using screw blades, for example, there is a method of contacting the components with a surface of a circular cylindrical roller. This method has a risk of crushing the components and damaging the components and the circular cylindrical roller rather than detaching the components because the circular cylindrical surface is constantly in contact with the components. However, the method of using the screw blades of the present invention does not cause these problems because the components are rolled up and detached or stripped off from the substrate. The pitch (or spacing) m between adjacent screw blades can be appropriately selected according to the diameter (outer diameter) of the screw blades, the arrangement of electronic components (for example, a distance between electronic components on a mounting substrate, etc.), and the size of electronic components. It is desirable that the pitch m is set to a value equal to or greater than the pitch at which the components (parts) to be detached is not pinched. For example, the pitch m is between 20 mm and 120 mm. Also, the pitch m may be changed depending on the number of the screw blades to be used. Although two screw blades are used in FIG.3, one screw blade or three or more screw blades may be used. The width (or thickness) of the tip of the blade can also be appropriately selected according to the size of the components, the distance between the components, the type of material of the components, the strength of the blade material, and the like. For example, it is between 5 mm and 15 mm. The height h of the blade and the outer diameter D of the blade can also be appropriately selected according to the size and arrangement of the electronic components, the type of the components, and the type of the mounting substrate. For example, it is desirable to make h and D small for small substrates and small components. By making them smaller, the load on the motor can also be reduced. For example, h is 5 mm to 20 mm and D is 15 mm to 50 mm. Larger values can be set if the substrate size is larger. The inclination angle β of the screw blade with respect to the rotary axis is, for example, 80 degrees to 50 degrees, but it can be appropriately selected according to the size of the blade, the size of the components, the distance between the components, the above m, h, D, and the like. The rotation speed of the blade roller can be appropriately selected depending on the size of the components, the arrangement of the components, the type of the substrate, the processing speed, and the like.

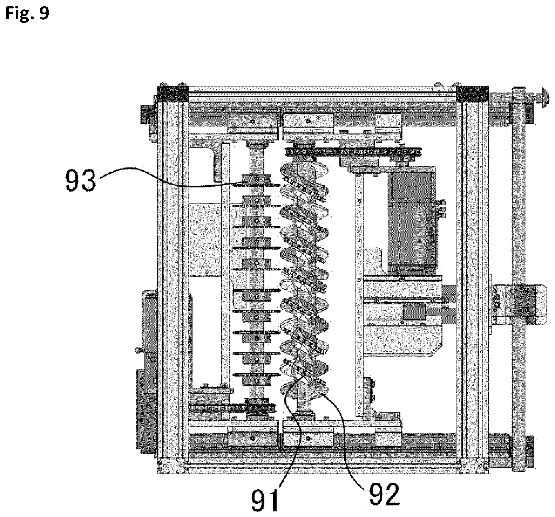

FIG.4 is a diagram showing the state of the mounting substrate and the screw blade rollers inside the apparatus for detaching substrate components. The screw blade rollers in the apparatus for detaching substrate components shown in FIG.4 are arranged in four stages. As shown in FIG.1, the mounting substrate 14 coming out of the substrate heating apparatus 12 enters the apparatus for detaching substrate components 11. And inside the apparatus for detaching substrate components 11, as shown in FIG.4, the substrate 14 advances from top to bottom of the apparatus for detaching substrate components as indicated by the arrows. In FIG.4, a mounting substrate 43 enters a gap (or clearance) 44 (44-1) between a feed roller 42 (42-1) and a screw blade roller 41 (41-1) arranged in the uppermost first stage. The feed roller 42 contacts and supports the rear (back) surface of the mounting substrate 43 to guide the feeding of the mounting substrate 43, and it rotates according to the feeding speed of the mounting substrate 43. Although the feed roller 42 is not mainly intended for detaching or stripping off the components, it can be made of a material that does not wear out even when repeatedly brought into contact with the mounting substrate. However, it can be also made of the same sturdy material as the screw blade. For example, materials of the feed roller include rubber, hard plastic, iron-based materials, and stainless materials. Since the mounting substrate 43 coming out of the substrate heating apparatus 12 is usually in a high temperature state of about 150° C or more, it is desirable to use a material having heat resistance above the operating temperature in the case of rubber or plastic or the like. The shape of the feed roller is, for example, a circular cylindrical shape or a disk shape. In the case of the circular cylindrical shape, it contacts (linearly) the entire rear surface of the substrate. In the case of the disk shape, for example, as shown in FIG.2 and FIG.9, if uneven portions like gears are formed in a circumferential direction, the uneven portions will catch on the rear surface of the substrate. As a result, the substrate can be sent downward and smoothly without slipping on the rear surface of the substrate. In addition, in the case of the circular cylindrical shape, if the uneven portions are formed on the side surface, since the uneven portions catch on the rear surface of the substrate, the substrate can be sent downward and smoothly without slipping on the rear surface of the substrate.

Since most of the electronic components 45 are mounted on the front surface of the substrate 43, the front surface of the substrate 43 is placed so as to face the screw blade roller 41. In FIG.4, the screw blade rollers 41 (41-1 to 4) and the feed rollers 42 (42-1 to 4) are arranged in four stages. The substrate 43 passes through the gap 44 (44-1 to 44-4) between the screw blade rollers 41 (41-1 to 4) and the feed rollers 42 (42-1 to 4) . It is desirable that the gaps (d1 to d4) between the screw blade rollers 41 and the feed rollers 42 decrease from the top to the bottom (that is, d1>d2>d3>d4). Therefore, if the diameters of the rollers are the same, the dashed line connecting the centers of the feed rollers 42 and the dashed line connecting the centers of the screw blade rollers 41 become closer as they go downward. Though a large number of electronic components 45 are mounted on the mounting substrate 43, since the height and size of the electronic components 45 from the surface of the substrate 43 are various, the gap d1 between the screw blade roller 41-1 and the feed roller 42-1 in the first stage is preferably set so as to be about the same as or slightly smaller than the maximum height (including the substrate thickness) of the electronic components mounted on the substrate. The gap d4 between the screw blade roller 41-4 and the feed roller 42-4 in the lowermost fourth stage is preferably set so as to be about the same as the minimum height (including the substrate thickness) of the electronic components mounted on the substrate. The gap d2 between the screw blade roller 41-2 and the feed roller 42-2 in the second stage in between the uppermost stage (the first stage in FIG.4) and the lowest stage (the fourth stage in FIG.4), and the gap d3 between the screw blade roller 41-3 and the feed roller 42-3 in the third stage in between the uppermost stage and the lowest stage are preferably set so as to be about halfway between them, respectively. The gap at the final stage (the fourth stage in FIG.4) is preferably set so as to be from the height (including the thickness of the substrate) of the smallest electronic component to the thickness of the substrate. By gradually reducing the gap in this manner, the highest electronic components can be detached or stripped off from the substrate at the first stage, and the next highest electronic components can be detached or stripped off from the substrate at the second stage, and the next highest electronic components can be detached or stripped off from the substrate at the third stage, and the lowest electronic components can be detached or stripped off from the substrate at the final fourth stage. As a result, almost all electronic components can be detached or stripped off from the mounting substrate 43 without difficulty. When the blade rollers are arranged in multiple stages, larger components or parts are detached sequentially from the front stage and smaller components or parts are detached at the rear stage. However, it can be also selected to widen the radius and pitch of the blades in the front stage and to narrow progressively the radius and pitch of the blades in the rear stage. As a result, the electronic components can be easily detached or stripped off from the mounting substrate without applying an excessive load to the screw blade rollers 41 and the screw blades, and without damaging the screw blade rollers 41, the screw blades and the feed rollers.

Although four stages of screw blade rollers are arranged in FIG.4, more stages may be used. Even in that case, the gaps can be made gradually smaller, but naturally they should be equal to or greater than the thickness of the mounting substrate. Also, the number of the stages of the screw blade rollers may be less than four. For example, two or three stages may be used. Even in that case, it is desirable to gradually reduce the gap. If the number of stages of the screw blade rollers in the apparatus is large, since the apparatus can apply to the mounting substrates on which the electronic components having various heights and sizes are mounted, the range of application is widened. When the screw blade rollers are arranged in multiple stages, the distance (center-to-center distance) between the screw blade rollers is, for example, the outer diameter + 5 mm to 30 mm, but it also depends on the size of the substrate and the outer diameter of the screw blade. For example, when the outer diameter is 80 to 100 mm, the distance between the screw blade rollers is 85 to 130 mm. If this distance is too large, it is difficult for a small substrate to advance to the next stage, and the size of the apparatus will increase. If the number of the stages of the screw blade rollers is one, the gap should be adjusted from about the height (including substrate thickness) of the smallest electronic component to about the thickness of the substrate. In this case, it is desirable that the heights of the electronic components are relatively uniform.

In addition, rotating the screw blade roller with respect to the substrate as much as possible increases the chances of detaching the electronic components. For example, if a diameter of the screw blade is 90 mm, the substrate typically travels about 280 mm if the lateral vector is ignored. Thus, for a 350 mm square substrate, one blade finishes feeding in about 1.2 revolutions. Therefore, it is preferable to reduce the substrate feeding speed by applying a brake to the substrate feeding. For example, the screw blade rollers of odd-numbered stages (first and third stages in the example of FIG.4) are rotated at high speed, and the screw blade rollers of the even-numbered stages (the second and fourth stages in the example of FIG.4) are rotated at low bottom speed. By arranging alternately high-speed rotating blade rollers and low-speed rotating blade rollers, the low-speed rotating blade rollers act as brakes, enabling the high-speed rotating blade rollers to rotate multiple times on the substrate, enabling a large number of electronic components mounted on the substrate to be detached from the substrate. This mechanism may be called a substrate braking system based on rotational speed difference.

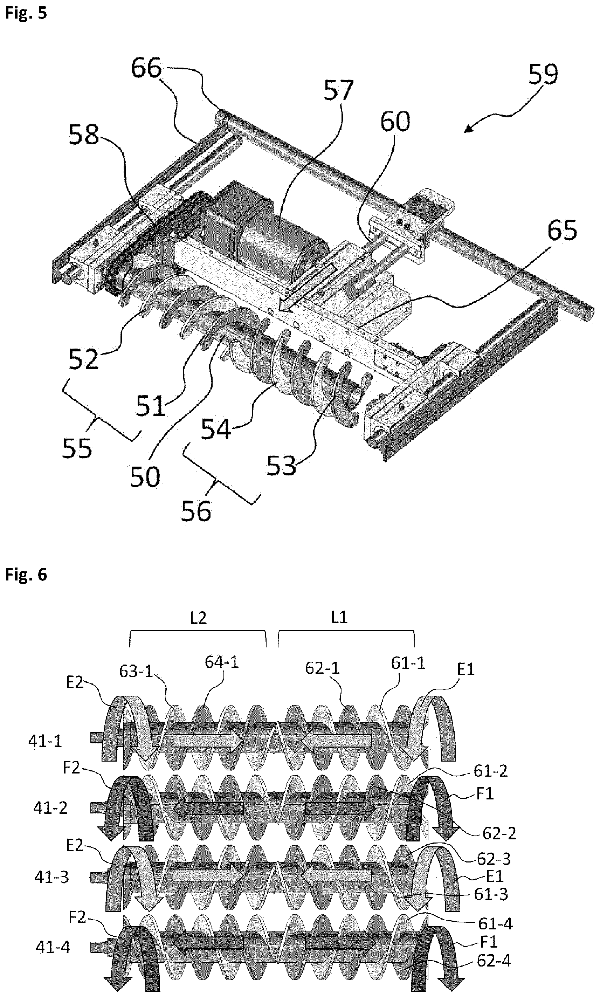

FIG.5 shows a suspension system 59 for a screw blade roller. Screw blades 51, 52, 53, 54 are attached to a rotary shaft 50. As also shown in FIG.3, two screw blades 51 and 52 (collectively referred to as 55) are wound around the rotary shaft 50 in a half the area of the rotary shaft 50, and two screw blades 53 and 54 (collectively referred to as 56) are wound around the rotary shaft 50 in the other half the area of the rotary shaft 50. The winding directions of these screw blades 55 and 56 are opposite. The rotary shaft 50 connects to a motor 57 via a transmission mechanism 58 such as a belt or a chain and it can arbitrarily rotate with the motor 57. Therefore, when the rotary shaft 50 rotates, the direction of travel of the screw blade 55 is opposite to that of the screw blade 56. Therefore, since the electronic components are rolled up in the opposite direction in each area, the force is offset or cancelled, and an excessive load is not applied to the rotary shaft and the motor.

The motor 57, the screw blades 55 and 56, the rotary shaft 50, and the like are attached to the frame 65 and integrated. Also, the frame 65 is attached to the framework 66 via a cylinder 60. The gap between the feed roller and the screw blade roller can be adjusted by adjusting or moving the position of the framework 66. Since there are uneven surfaces on the substrate due to electronic components, etc. on the substrate, the cylinder 60 can also be used as a suspension in order to always press the blade against the uneven substrate with the same force. This pressing force can be adjusted, for example, by an air regulator. This suspension mechanism (or system) allows the electronic components to be easily detached or stripped without excessive damage. Also, since the motor 57, the screw blades 55 and 56, and their rotary shaft 50, etc. are not subjected to excessive loads, they are not damaged.

Figure 6 is a diagram showing the function of the multiple stage screw blades in the apparatus for detaching substrate components. The first stage screw blade roller 41-1 has two screw blades 61-1 and 62-1 wound and attached in a half region L1 of the rotary shaft, and two screw blades 63-1 and 64-1 wound and attached in the other half region L2 of the rotary shaft. As previously indicated, the winding directions of the screw blades in the regions L1 and L2 are opposite each other. When the first stage screw blade roller 41-1 rotates to send the substrate downward, as shown in FIG.6, in both regions L1 and L2, the screw blades rotate so that the screw blades travel to the inward directions E1 and E2. As a result, a force is generated that rips off the electronic components in the lateral direction from the right and left sides (or outward) of the rotary shaft toward the center (or inward) of the rotary shaft, as indicated by the straight arrows.

The second stage screw blade roller 41-2 has two screw blades 61-2 and 62-2 wound and attached in a half region L1 of the rotary shaft, and two screw blades (numbers omitted) wound and attached in the other half region L2 of the rotary shaft. In the second stage screw blade roller 41-2, the winding directions of the screw blades in the regions L1 and L2 are opposite. Also, in the regions L1, the winding directions of the screw blades of the first stage screw blade roller 41-1 and the second stage screw blade roller 41-2 are opposite. That is, the winding directions of the screw blades 61-2 and 62-2 in the second stage screw blade roller 41-2 are opposite to the winding directions of the screw blades 61-1 and 62-1 in the first stage screw blade roller 41-1. Similarly, in the region L2, the winding directions of the screw blades in the first stage screw blade roller 41-1 are opposite to the winding directions of the screw blades in the second stage screw blade roller 41-2. When the second stage screw blade roller 41-2 rotates to send downward the substrate sent from the first stage screw blade roller 41-1, as shown in FIG.6, in both regions L1 and L2, the screw blades rotate so that the screw blades travel to the outward directions F1 and F2. As a result, a force is generated that rips off the electronic components in the lateral direction from the center (or inward) of the rotary shaft toward the right and left sides (or outward) of the rotary shaft, as indicated by the straight arrows.

In the third stage screw blade roller 41-3, two screw blades 61-3 and 62-3 are wound and attached in a half region L1 of the rotary shaft, and two screw blades (numbers omitted) are wound and attached in the other half region L2 of the rotary shaft. In the third stage screw blade roller 41-3, the winding directions of the screw blades in the regions L1 and L2 are also opposite. In the region L1, the winding directions of the screw blades of the second stage screw blade roller 41-2 and the third stage screw blade roller 41-3 are opposite to each other. When the third stage screw blade roller 41-3 rotates to send downward the substrate sent from the second stage screw blade roller 41-2, as shown in FIG.6, in both regions L1 and L2, the screw blades rotate so that the screw blades travel to the inward directions E1 and E2. As a result, a force is generated that rips off the electronic components in the lateral direction from the right and left sides (or outward) of the rotary shaft toward the center (or inward) of the rotary shaft, as indicated by the straight arrows.

In the fourth stage screw blade roller 41-4, two screw blades 61-4 and 62-4 are wound and attached in a half region L1 of the rotary shaft, and two screw blades (numbers omitted) are wound and attached in the half region L2 of the rotary shaft. In the fourth stage screw blade roller 41-4, the winding directions of the screw blades in the regions L1 and L2 are also opposite to each other. In the region L1, the winding directions of the screw blades of the third stage screw blade roller 41-3 and the fourth stage screw blade roller 41-4 are opposite to each other. That is, the winding directions of the screw blades 61-4 and 62-4 in the fourth stage screw blade roller 41-4 are opposite to the winding directions of the screw blades 61-3 and 62-3 in the third stage screw blade roller 41-3. Similarly, in the region L2, the winding directions of the screw blades of the third stage screw blade roller 41-3 and the fourth stage screw blade roller 41-4 are opposite to each other. When the fourth stage screw blade roller 41-4 rotates to send downward the substrate sent from the third stage screw blade roller 41-3, as shown in FIG.6, in both regions L1 and L2, the screw blades rotate so that the screw blades travel to the outward directions F1 and F2. As a result, a force is generated that rips off the electronic components in the lateral direction from the center (or inward) of the rotary shaft toward the right and left sides (or outward) of the rotary shaft, as indicated by the straight arrows.

In this way, by alternately arranging two types of screw blade rollers, it is possible to apply forces (or vectors) in the opposite direction to the components mounted on the substrate (this is called an anti-vector generation system in the apparatus for detaching substrate components). Therefore, it is possible to smoothly move the substrate downward while preventing the substrate from moving laterally or obliquely. It is also possible to drop the detached electronic components downward without being flipped laterally. The same effect can be obtained even if the order of the two types of screw blade rollers is reversed from that shown in FIG.6.

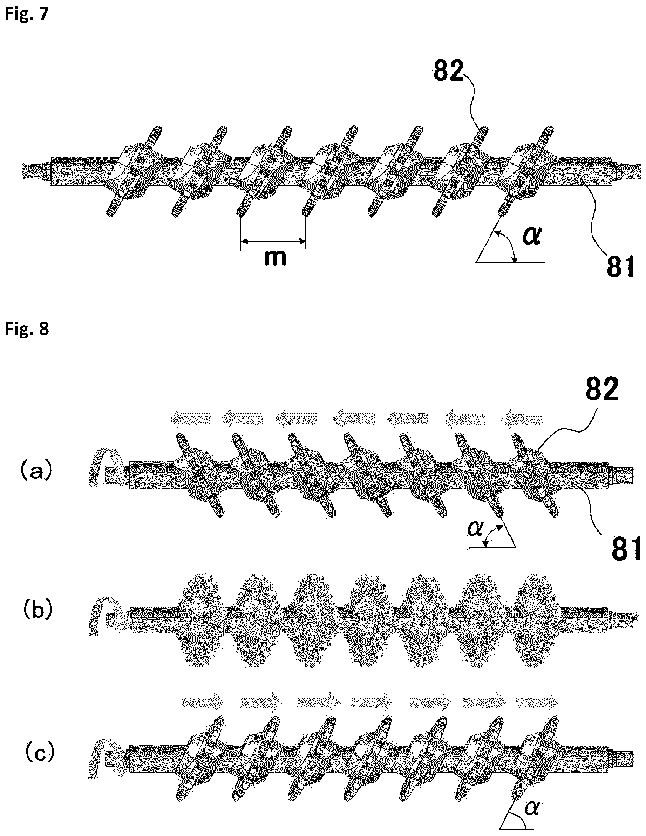

So far, although the screw blades have been described as detaching or stripping blades, instead of or in addition to these, blades inclined with respect to the rotary shaft can also be used. FIG.7 is a diagram showing a second embodiment of the detaching or stripping blades. The detaching blades shown in FIG.7 is inclined at a certain or fixed angle with respect to the rotary shaft 81. These blades are, for example, gear blades 82, which are attached to the rotary shaft 81 with an angle α. The diameters of the gear blades 82 may be appropriately selected depending on the size of the substrate mounting the components to be detached, and is, for example, 15 mm to 150 mm. The pitch (or distance) m between the gear blades 82 may be appropriately selected depending on the diameter of the gear blades 82, the distance between the electronic components mounted on the mounting substrate, the size of the electronic components to be detached, and the like, for example, 20mm to 120mm. A blade roller fitted with these inclined gear blades is called an inclined blade roller. Since the gear blades of this inclined blade roller are eccentric (or inclined) with respect to the rotary shaft, the clearance (or gap or interval) between the mounting substrate and the gear blades changes while rotating. As a result, since the mounting substrate can be vibrated, the electronic components can be easily detached or stripped off.

FIG.8 is a diagram showing the movement or operation of the inclined blade roller. Since the gear blades 82 in the inclined blade roller are attached at an angle α with respect to the rotary axis 81, when viewed from the same direction, a state of the gear blade 82 changes when the inclined blade roller rotates. For example, when the inclined blade roller rotates 180 degrees (in the direction of the rotation arrow) from a state inclined at an angle α as shown in FIG.8(a), the gear blades 82 are inclined with respect to the rotary shaft 81 at the inclination angle α opposite to that in FIG.8(a), as shown in FIG.8(c). Further rotation of the inclined blade roller by 180 degrees (in the direction of the rotation arrow) results in the state shown in Figure 8(a). In their middle, the state is shown in FIG.8(b). That is, when the inclined blade roller rotates once, the gear blade 82 continuously changes from angle α to -α and then from -α to α. As a result, since the rotation of the gear blade 82 of the inclined blade roller is converted into a motion scratching the components from side to side on the mounting substrate, the electronic components on the substrate can be detached or stripped off. The angle α is, for example, 50 to 80 degrees, but it can be appropriately selected depending on the spacing m between the gear blades 82, the diameter of the gear blades 82, the distance between the components, the size of the electronic components, the type of the substrate, the size of the substrate, and the like.

The number of gear teeth (the number of teeth of the gear on the circumference) can be appropriately selected depending on the interval and arrangement of the components, the size of the components, the radius of the gears, the type of the substrates, and the like. For example, the radius of the gear is 30mm to 60mm and the number of gear teeth is 10 to 100. The groove depth (or tooth depth) of the gear can be appropriately selected depending on the radius of the gears, the size of the components, and the like. For example, if the gear radius is 50mm, the tooth depth is between 5mm and 20mm. The radius of the rotary shaft can also be appropriately selected depending on the radius of the gears, the size of the electronic components, and the like. For example, the radius of the rotary shaft is between 5 mm and 40 mm. The thickness (at the tip) of the gear can be appropriately selected depending on the interval between components, the arrangement of components, the size of components, the strength of components, and the like. For example, the thickness (at the tip) of the gear is 5 mm to 20 mm. The rotation speed of the blade roller can be appropriately selected depending on the size of the components, the arrangement of the components, the processing speed, and the like. The gear blades are inclined in one direction in Figure 8, but they can be also mixed with gear blades inclined in the opposite direction. For example, the gear blades in the left half area of the inclined blade roller may be inclined in one direction (or positive direction) (at inclination angle α) and the gear blades in the right half area of the inclined blade roller may be inclined in the opposite direction (or negative direction) (at inclination angle -α). Also, Gear blades with alternating positive and opposite (or negative) inclination angles can also be employed. In that case, the inclination angles of the gear blades can also be changed. Since the gear blades come into contact with the components such as electronic components mounted on the mounting substrate while rotating and separate those components from the mounting substrate, the gear blades are made of materials that are harder, stronger, and wears less than the material of the components. For example, their materials include steel materials such as SS400 and stainless materials such as SUS304.

FIG.9 is a top view of the apparatus for detaching substrate components viewed from the direction that the mounting substrate enters. An inclined blade roller 91 is positioned above the screw blade roller 92. Therefore, the mounting substrate coming out of the substrate heating apparatus first enters the gap between the inclined blade roller 91 and a feed roller 93, and then the inclined blade roller 91 traces the surface of the mounting substrate to detach or strip off the electronic components mounted on the mounting substrate. The mounting substrate then enters the gap between the screw blade roller 92 and a next feed roller that is located under the feed roller 93, where the electronic components that have not been detached or stripped off are removed or detached. If optimized, it is possible to separate or detach the electronic components by arranging only one stage of the inclined blade roller 91, or by using two stages of the inclined blade roller 91 and the screw blade roller 92 as shown in FIG.9. Furthermore, by placing an inclined blade roller or a screw blade roller under the screw blade roller 92, it is possible to appropriately select a multi-stage blade roller such as 3 stages or 4 stages to completely detach or strip off the electronic components without difficulty. The inclined blade rollers can also be arranged continuously in multiple stages. Even when multiple stages of blade rollers (for detaching or stripping) are arranged, if the gap between the blade roller and the feed roller is made smaller as the stage moves to the lower stage or the next stage, components with different heights and sizes can be detached or stripped off in order. If components are also mounted on the backside of the substrate and are to be detached, a detaching or stripping blade roller such as a screw blade roller or an inclined blade roller can be also attached as a feed roller. Since the detaching or stripping blade of the present invention employs a structure that does not apply excessive force during rotation and detaching or stripping, even if the detaching or stripping blades are used on both sides of the substrate, the blades, blade rollers, motors and other members are neither overloaded nor damaged.

Since the apparatus for detaching substrate components of the present invention described so far has the blade rollers positioned longitudinally (or vertically) and moves the substrate from above to below, the components can be detached or stripped off without increasing the floor area, and the size of the apparatus can be made smaller. However, if there is no limit to the floor area, the blade rollers can be arranged horizontally to move the mounting substrate in the lateral direction (or horizontal direction), and the same effect as those of vertical movement can be achieved.

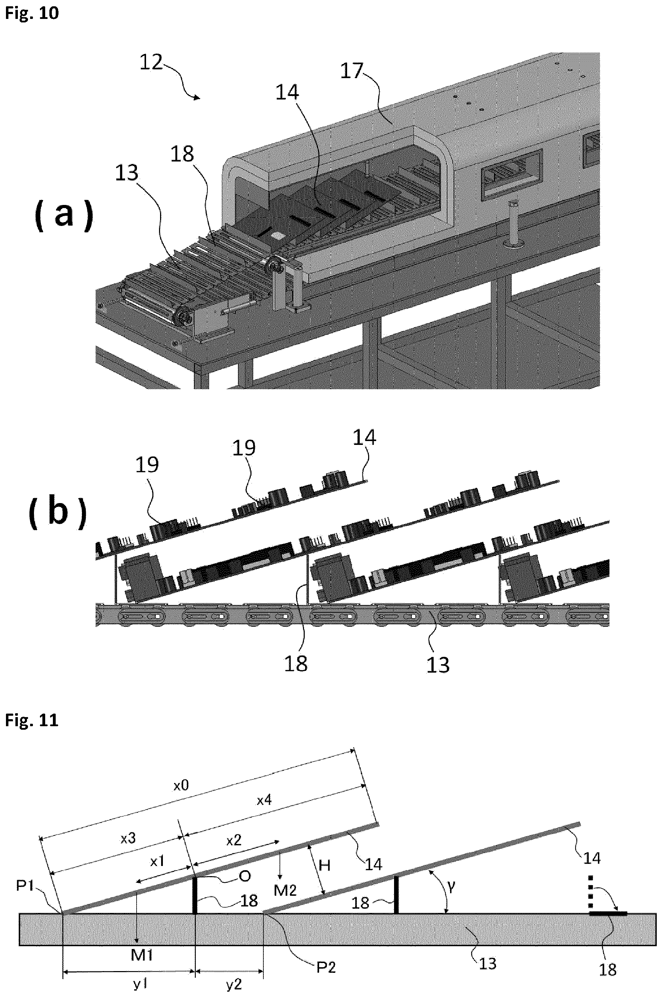

FIG.10 is a diagram showing a method of transporting the mounting substrate in the substrate heating apparatus shown in FIG.1. FIG.10(a) is a diagram showing how the mounting substrate 14 placed on the conveyor belt 13 is conveyed in the heating furnace 17. A portion of the outer cover of the heating furnace 17 is removed so that the state of the mounting substrate inside can be seen. FIG.10(b) is an enlarged view thereof. Various components 19 such as ICs, resistors, capacitors, and many other electronic components are mounted on the mounting substrate 14. A portion of the mounting substrate 14 is placed on a projecting plate 18 attached to the conveyor belt 13 and the mounting substrate is conveyed into the heating furnace 17 by the conveyor belt 13. The mounting substrate 14 is carried at a tilt because a part of the mounting substrate 14 is placed on the projection plate 18. This type of conveyor is called a substrate tilting conveyor. Compared to the method of simply placing the mounting substrates 14 side by side on the conveyor belt 13, a large number of mounting substrates can be transported without overlapping. The mounting substrate 14 transported or carried in a tilted state is processed in the heating furnace 17 at a temperature of about 200° C to 500° C in an atmosphere of superheated steam, nitrogen, air, or the like. These heating conditions are appropriately selected depending on the material of the mounting substrate and the type of solder or adhesive used to adhere the electronic components to the mounting substrate, and these adhesives are softened or melted. The mounting substrate 14 is conveyed to the heating area of the heating furnace 17 by the conveyor belt 13 and heated at a predetermined temperature for a certain period of time (for example, 1 to 10 minutes) . Heating of the mounting substrate 14 may be performed while the conveyor belt 13 and the mounting substrate 14 are moving, or the mounting substrate 14 may be heated while the conveyor belt 13 is stopped at the heating area in order to shorten the heating area and reduce the size of the apparatus. The number of the mounting substrates 14 processed is determined by the heating time, the length of the heating area, the speed of the conveyor (belt) passing through the heating area, and the like.

Such the substrate tilting conveyor can heat-treat a large number of mounting substrates without overlapping them. As shown in Figure 10, since adjacent mounting substrates do not overlap each other and there is a gap between them, heat can be transferred to each mounting substrate 14 even if a heat source is placed below the furnace body (for example, below the conveyor belt 13) or above the furnace body, or even when the entire atmosphere in the heating furnace is heated. In the substrate tilting conveyor of the present invention, before the mounting substrate 14 is placed on the conveyor belt 13, the projecting plate 18 folded on the conveyor belt 13 is lifted and the mounting substrate 14 is placed at a predetermined position on the projecting plate 18. This predetermined position can be determined from the length of the mounting substrate 14 or the weight (including components) of the mounting substrate before and behind the predetermined position that is a supporting point. Further, the height of the projecting plate 18 and the distance between the projecting plates can be appropriately set according to the length of the mounting substrate, the height of the component having the maximum height among the components mounted on the mounting substrate, and the like. The width side of the projecting plate 18 may contact the entire width direction of the mounting substrate 14 to support the mounting substrate 14, or it may partially contact the width direction of the mounting substrate 14 to support the mounting substrate 14. After heating, the mounting substrate 14 comes out of the heating furnace 17 and enters the apparatus for detaching substrate components 11, as shown in FIG.1. The projecting plate 18 standing on the conveyor belt 13 falls forward and is folded onto the conveyor belt 13. Correspondingly, the tilt angle of the tilted mounting substrate 14 gradually decreases, and the mounting substrate 14 descends to the apparatus for detaching substrate components 11 at the place where the conveyor belt 13 turns downward, and the mounting substrate 14 enters smoothly the gap between the first-stage blade roller and feed roller.

FIG.11 is a diagram showing a state in which the mounting substrate is placed on the protruding or projecting plate, and schematically shows the diagram shown in FIG.10(b). A part of the mounting substrate 14 is placed on the projecting plate 18 at a point O, and one end of the mounting substrate is supported at a point P1 or P2 of the conveyor belt 13. Naturally, there is a depth (in the width direction of the conveyor belt 13), so the mounting substrate is linearly supported at the point P1 or P2 and at the point O. A length of the mounting substrate 14 is x0, a length of the mounting substrate from the contact point O to the point P1 on the mounting substrate is x3, a length of the mounting substrate from the contact point O to the other end of the mounting substrate is x4 (=x0-x3), a weight of the mounting substrate (including mounted components, etc.) in the mounting substrate x3 is M1, and a weight of the mounting substrate (including mounted components, etc.) in the mounting substrate x4 is M2. A distance from the point O to the gravity center of the mounting substrate in the x3 portion of the mounting substrate is x1, and a distance from the point O to the gravity center of the mounting substrate in the x4 portion of the mounting substrate is x2. If M1x1>M2x2 from the moment around the point O, the mounting substrate 14 is stably placed on the conveyor belt 13. For example, if a heavy component is placed on the x3 portion of the mounting substrate, the contact point O of the mounting substrate 14 and the projecting plate 18 can be brought before the center point of the mounting substrate 14. That is, by grasping the weight distribution of the mounting substrates in advance, a distance y1 from the point P1 to the projecting plate 18 can be shortened, so that many mounting substrates can be processed.

Let L be the length of the projecting plate 18 (height when standing: standing height), γ be the tilt angle of the mounting substrate 14, and y1 be the distance from the point P1 to the projecting plate 18, then tanγ=L/y1 and sinγ=L/x3. Assuming that the distance from one projecting plate 18 to the adjacent projecting plate 18 is y2 and the distance between the projecting plates is H, sinγ=H/ (y1+y2). From these, H=L(y1+y2)/x3. If the maximum height among the components mounted on the mounting substrate 14 is H0, then H>H0. Accordingly, the projecting plate spacing (or interval) (y1+y2), the mounting substrate length (x3), and the projecting plate length L may be selected so as to make H as small as possible while satisfying the above relationship, that is, H>H0. As shown in FIG.11, if the projecting plate 18 is folded (or laid) from an upright state (indicated by broken lines) to an advancing side (or rightward in FIG.11) of the conveyor belt 13, the mounting substrate 14 also lies down and is placed on the conveyor belt 13. Since the conveyor belt 13 turns downward at the right end of the substrate heating apparatus 12, the mounting substrate 14 placed on the conveyor belt 13 descends to the apparatus for detaching substrate components 11. The above values can be appropriately selected and set depending on the size, weight, etc. of the mounting substrate. If a large number of projecting plates are arranged and the projecting plates to be erected are selected according to the size and weight of the mounting substrate, it is possible to use the mounting substrates with various sizes and weights, and it is possible to heat-treat a large number of mounting substrates.

As detailed above, the apparatus for detaching substrate components of the present invention brings a screw blade or a gear blade into contact with the electronic components or the like mounted on the surface of a mounting substrate, and the electronic components are detached or stripped off, as if they may be plucked, by the rotative force of the blades. As a result, the apparatus for detaching substrate components of the present invention can detach the electronic components and the like without damaging them and does not give excessive load to the blade roller. In addition, since the substrate heating apparatus arranged in front of the apparatus for detaching substrate components can tilt and convey the mounting substrates by means of the projecting plate provided on the conveyor belt, a large number of mounting substrates can be heat-treated.

### INDUSTRIAL APPLICABILITY

In the apparatus for detaching substrate components of the present invention, the blade rollers can be also arranged in the horizontal direction to move the substrate in the horizontal direction, and the electronic component or the like can be detached from the mounting substrate.

### REFERENCE SIGNS LIST

11 an apparatus for detaching substrate components, 12 a substrate heating apparatus, 13 a conveyor belt, 14 a mounting substrate, 15 a trestle, 16 an observation window, 17 a heating furnace, 18 a projecting plate, 19 a component, 21 a blade roller, 22 a feed roller, 30 a screw blade roller, 31 a screw blade, 32 a screw blade, 33 a screw blade, 34 a screw blade, 35 a rotary shaft, 41 a screw blade roller, 42 a feed roller, 43 a mounting substrate, 44 a gap, 50 a rotary shaft, 51 a screw blade, 52 a screw blade, 53 a screw blade, 54 a screw blade, 55 a screw blade, 56 a screw blade, 57 a motor, 58 a transmission mechanism, 59 a suspension system, 60 a cylinder, 61 a screw blade, 62 a screw blade, 63 a screw blade, 64 a screw blade, 65 a frame, 66 a framework, 81 a rotary shaft, 82 a gear blade, 91 an inclined blade roller, 92 a screw blade roller, 93 a feed roller,

In the apparatus for detaching substrate components of the present invention, the blade rollers can be also arranged in the horizontal direction to move the substrate in the horizontal direction, and the electronic component or the like can be detached from the mounting substrate.

### REFERENCE SIGNS LIST

11 an apparatus for detaching substrate components, 12 a substrate heating apparatus, 13 a conveyor belt, 14 a mounting substrate, 15 a trestle, 16 an observation window, 17 a heating furnace, 18 a projecting plate, 19 a component, 21 a blade roller, 22 a feed roller, 30 a screw blade roller, 31 a screw blade, 32 a screw blade, 33 a screw blade, 34 a screw blade, 35 a rotary shaft, 41 a screw blade roller, 42 a feed roller, 43 a mounting substrate, 44 a gap, 50 a rotary shaft, 51 a screw blade, 52 a screw blade, 53 a screw blade, 54 a screw blade, 55 a screw blade, 56 a screw blade, 57 a motor, 58 a transmission mechanism, 59 a suspension system, 60 a cylinder, 61 a screw blade, 62 a screw blade, 63 a screw blade, 64 a screw blade, 65 a frame, 66 a framework, 81 a rotary shaft, 82 a gear blade, 91 an inclined blade roller, 92 a screw blade roller, 93 a feed roller,

## Claims

1. An apparatus for detaching substrate components (11), which is configured to detach electronic components mounted on a substrate, the apparatus for detaching substrate components having a screw blade roller (30, 41, 92) with a screw blade (31, 32, 33, 34, 51, 52, 53, 54, 55, 56, 61, 62, 63, 64) attached to a rotary shaft (35, 50, 81),
wherein the screw blade (31, 32, 33, 34, 51, 52, 53, 54, 55, 56, 61, 62, 63, 64) is helical or spiral or screw shaped blade attached to the rotary shaft in such a way that it winds around the shaft in a helical, spiral or screw shape,
wherein the screw blade roller (30, 41, 92) is configured to come into contact with the electronic components mounted on the substrate and is configured to detach the electronic components while the screw blade roller (30, 41, 92) rotates,
wherein two or more screw blades (31, 32, 33, 34, 51, 52, 53, 54, 55, 56, 61, 62, 63, 64) are attached to the rotary shaft (35, 50, 81) of the screw blade roller (30, 41, 92),and
wherein the winding direction of the screw blade in one side of the screw blade roller is opposite to the winding direction of the screw blade in the other side of the screw blade roller.

2. The apparatus for detaching substrate components according to claim 1,
wherein the screw blade roller (30, 41, 92) is configured to be placed in a front surface of the substrate, many components being mounted in the front surface of the substrate, and
wherein a feed roller (22, 42, 93) supporting a back surface of the substrate is configured to be placed in the back surface of the substrate.

3. The apparatus for detaching substrate components according to claim 1 or 2,
wherein the screw blade rollers (30, 41) are placed in multiple stages, the substrate entering the screw blade roller (30, 41) in the front stage and then entering the screw blade roller (30, 41) in the subsequent stage.

4. The apparatus for detaching substrate components according to claim 3,
wherein the winding direction of the screw blade (61, 62, 63, 64) of the screw blade roller (41) in an odd numbered stage is opposite to the winding direction of the screw blade of the screw blade roller (41) in an even numbered stage.

5. The apparatus for detaching substrate components according to claim 3 or 4,
when the screw blade rollers (41) are placed in multiple stages, in the gap between the screw blade roller (41) and the feed roller (42), the gap in the front stage is smaller than the gap in the subsequent stage.

6. The apparatus for detaching substrate components according to any one of claims 1 to 5,
the apparatus for detaching substrate components further having an inclined blade roller fitted with a gear blade (82) inclined with respect to the rotary shaft (81).

7. The apparatus for detaching substrate components according to claim 6,
the inclined blade roller (91) being placed in front of the screw blade roller (92).

8. A system for detaching substrate components having a substrate heating apparatus (12) in front of the apparatus for detaching substrate components according to any one of claims 1 to 6,
the substrate heated by the substrate heating apparatus being inserted into the apparatus for detaching substrate components.

9. The system for detaching substrate components according to claim 8, the substrate heating apparatus having a conveyor for carrying the substrate to a heating furnace (17) in the substrate heating apparatus, and
the conveyor being equipped with a projecting plate (18) on which a part of the substrate is placed so that the substrate can be conveyed while being tilted.

10. The system for detaching substrate components according to claim 9,
the substrates being prevented from overlapping each other.

11. The system for detaching substrate components according to claim 9 or 10,
in the heating furnace (17) of the substrate heating apparatus, the substrate being heated while the substrate is placed on the projecting plate (18) of the conveyor.

12. The system for detaching substrate components according to any one of claims 9 to 11,
the projecting plate (18) can be folded on the conveyor belt (13) of the conveyor,
wherein the projecting plate (18) is erected when the mounting substrate (14) is placed on the projecting plate (18), and
wherein the projecting plate (18) is folded when the mounting substrate (14) is not placed on the projecting plate (18).

## Patentansprüche

1. Eine Vorrichtung zum Ablösen von Substratkomponenten (11), die dazu konfiguriert ist, auf einem Substrat montierte elektronische Komponenten abzulösen, wobei die Vorrichtung zum Ablösen von Substratkomponenten eine Schraubenblattwalze (30, 41, 92) mit einem Schraubenblatt (31, 32, 33, 34, 51, 52, 53, 54, 55, 56, 61, 62, 63, 64), die an einer Drehwelle (35, 50, 81) befestigt ist, aufweist,
wobei das Schraubenblatt (31, 32, 33, 34, 51, 52, 53, 54, 55, 56, 61, 62, 63, 64) ein helixförmiges, spiralförmiges oder schraubenförmiges Blatt ist, das so an der Drehwelle befestigt ist, dass es sich helixförmig, spiralförmig oder schraubenförmig um die Welle windet,
wobei die Schraubenblattwalze (30, 41, 92) dazu konfiguriert ist, mit den auf dem Substrat montierten elektronischen Komponenten in Kontakt zu kommen, und dazu konfiguriert ist, um die elektronischen Komponenten abzulösen, während sich die Schraubenblattwalze (30, 41, 92) dreht,
wobei zwei oder mehr Schraubenblätter (31, 32, 33, 34, 51, 52, 53, 54, 55, 56, 61, 62, 63, 64) an der Drehwelle (35, 50, 81) der Schraubenblattwalze (30, 41, 92) angebracht sind, und
wobei die Wickelrichtung des Schraubenblatts auf einer Seite der Schraubenblattwalze entgegengesetzt zur Wickelrichtung des Schraubenblatts auf der anderen Seite der Schraubenblattwalze ist.

2. Die Vorrichtung zum Ablösen von Substratkomponenten nach Anspruch 1,
wobei die Schraubenblattwalze (30, 41, 92) dazu konfiguriert ist, an einer Vorderseite des Substrats angeordnet zu werden,
wobei zahlreiche Komponenten auf der Vorderfläche des Substrats montiert sind, und
wobei eine Zuführwalze (22, 42, 93), die eine Rückfläche des Substrats stützt, dazu konfiguriert ist, an der Rückfläche des Substrats angeordnet zu werden.

3. Die Vorrichtung zum Ablösen von Substratkomponenten nach Anspruch 1 oder 2,
wobei die Schraubenblattwalze (30, 41) in mehreren Stufen angeordnet sind,
wobei das Substrat in die Schraubenblattwalze (30, 41) der vorderen Stufe eintritt und anschließend in die Schraubenblattwalze (30, 41) der nachfolgenden Stufe eintritt.

4. Die Vorrichtung zum Ablösen von Substratkomponenten nach Anspruch 3,
wobei die Wickelrichtung des Schraubenblatts (61, 62, 63, 64) der Schraubenblattwalze (41) in einer ungeradzahligen Stufe entgegengesetzt zur Wickelrichtung des Schraubenblatts der Schraubenblattwalze (41) in einer geradzahligen Stufe ist.

5. Die Vorrichtung zum Ablösen von Substratkomponenten nach Anspruch 3 oder 4, wobei,
wenn die Schraubenblattwalzen (41) in mehreren Stufen angeordnet sind, im Spalt zwischen der Schraubenblattwalze (41) und der Zuführwalze (42) der Spalt in der vorderen Stufe kleiner ist als der Spalt in der nachfolgenden Stufe.

6. Die Vorrichtung zum Ablösen von Substratkomponenten nach irgendeinem der Ansprüche von 1 bis 5,
wobei die Vorrichtung zum Ablösen von Substratkomponenten ferner eine geneigte Blattwalze aufweist, die mit einem relativ zur Drehwelle (81) geneigten Zahnblatt (82) ausgestattet ist.

7. Die Vorrichtung zum Ablösen von Substratkomponenten nach Anspruch 6,
wobei die geneigte Blattwalze (91) vor der Schraubenblattwalze (92) angeordnet ist.

8. Ein System zum Ablösen von Substratkomponenten mit einer Substraterwärmungsvorrichtung (12) vor der Vorrichtung zum Ablösen von Substratkomponenten nach irgendeinem der Ansprüche von 1 bis 6,
wobei das durch die Substraterwärmungsvorrichtung erwärmte Substrat in die Vorrichtung zum Ablösen von Substratkomponenten eingeführt wird.

9. Das System zum Ablösen von Substratkomponenten nach Anspruch 8,
wobei die Substraterwärmungsvorrichtung einen Förderer zum Befördern des Substrats zu einem Heizofen (17) in der Substraterwärmungsvorrichtung aufweist, und
wobei der Förderer mit einer vorstehenden Platte (18) ausgestattet ist, auf der ein Teil des Substrats so platziert wird, dass das Substrat befördert werden kann, während es geneigt ist.

10. Das System zum Ablösen von Substratkomponenten nach Anspruch 9,
wobei verhindert wird, dass sich die Substrate gegenseitig überlappen.

11. Das System zum Ablösen von Substratkomponenten nach Anspruch 9 oder 10,
wobei das Substrat im Heizofen (17) der Substratheizvorrichtung erhitzt wird, während das Substrat auf der vorstehenden Platte (18) des Förderers aufliegt.

12. Das System zum Ablösen von Substratkomponenten nach irgendeinem der Ansprüche von 9 bis 11,
wobei die vorstehende Platte (18) auf das Förderband (13) des Förderers gefaltet werden kann,
wobei die vorstehende Platte (18) aufgerichtet ist, wenn das Montagesubstrat (14) auf die vorstehende Platte (18) platziert ist, und
wobei die Vorsprungplatte (18) gefaltet ist, wenn das Montagesubstrat (14) nicht auf der Vorsprungplatte (18) platziert ist.

## Revendications

1. Un dispositif de détachement de composants de substrat (11), qui est configuré pour détacher des composants électroniques montés sur un substrat, ledit dispositif de détachement de composants de substrat présentant un rouleau à lames en vis (30, 41, 92) muni d'une lame en vis (31, 32, 33, 34, 51, 52, 53, 54, 55, 56, 61, 62, 63, 64) fixée à un arbre rotatif (35, 50, 81),
sachant que la lame en vis (31, 32, 33, 34, 51, 52, 53, 54, 55, 56, 61, 62, 63, 64) est une lame hélicoïdale, en spirale ou en forme de vis fixée à l'arbre rotatif de manière qu'elle s'enroule autour de l'arbre selon une forme hélicoïdale, en spirale ou en forme de vis,
sachant que le rouleau à lames en vis (30, 41, 92) est configuré pour entrer en contact avec les composants électroniques montés sur le substrat et est configuré pour détacher les composants électroniques lorsque le rouleau à lames en vis (30, 41, 92) tourne,
sachant que deux lames en vis ou plus (31, 32, 33, 34, 51, 52, 53, 54, 55, 56, 61, 62, 63, 64) sont fixées à l'arbre rotatif (35, 50, 81) du rouleau à lames en vis (30, 41, 92), et
sachant que le sens d'enroulement de la lame en vis d'un côté du rouleau à lames en vis est opposé au sens d'enroulement de la lame en vis de l'autre côté du rouleau à lames en vis.

2. Le dispositif de détachement de composants de substrat d'après la revendication 1,
sachant que le rouleau à lames en vis (30, 41, 92) est configuré pour être placé sur une surface avant du substrat, de nombreux composants étant montés sur la surface avant du substrat, et
sachant qu'un rouleau d'alimentation (22, 42, 93) supportant une surface arrière du substrat est configuré pour être placé sur la surface arrière du substrat.

3. Le dispositif de détachement de composants de substrat d'après la revendication 1 ou 2,
sachant que les rouleaux à lames en vis (30, 41) sont disposés en plusieurs étages,
le substrat entrant dans le rouleau à lames en vis (30, 41) de l'étage avant, puis entrant dans le rouleau à lames en vis (30, 41) de l'étage suivant.

4. Le dispositif de détachement de composants de substrat d'après la revendication 3,
sachant que le sens d'enroulement de la lame en vis (61, 62, 63, 64) du rouleau à lames en vis (41) dans un étage impair est opposé au sens d'enroulement de la lame en vis du rouleau à lames en vis (41) dans un étage pair.

5. Le dispositif de détachement de composants de substrat d'après la revendication 3 ou 4,
sachant que, lorsque les rouleaux à lames en vis (41) sont disposés en plusieurs étages, dans l'écartement entre le rouleau à lames en vis (41) et le rouleau d'alimentation (42) l'écartement de l'étage avant est inférieur à l'écartement de l'étage suivant.

6. Le dispositif de détachement de composants de substrat d'après l'une quelconque des revendications de 1 à 5,
le dispositif de détachement de composants de substrat présentant en outre un rouleau à lames inclinés muni d'une lame dentée (82) inclinée par rapport à l'arbre rotatif (81).

7. Le dispositif de détachement de composants de substrat d'après la revendication 6,
le rouleau à lames inclinés (91) étant placé en avant du rouleau à lames en vis (92).

8. Un système de détachement de composants de substrat, présentant un dispositif de chauffage de substrat (12) devant le dispositif de détachement de composants de substrat d'après l'une quelconque des revendications de 1 à 6,
le substrat chauffé par le dispositif de chauffage de substrat étant introduit dans le dispositif de détachement de composants de substrat.

9. Le système de détachement de composants de substrat d'après la revendication 8,
sachant que le dispositif de chauffage de substrat présente un convoyeur destiné à acheminer le substrat vers un four de chauffage (17) dans le dispositif de chauffage de substrat, et
le convoyeur étant équipé d'une plaque saillante (18) sur laquelle une partie du substrat est placée de manière que le substrat puisse être convoyé tout en étant incliné.

10. Le système de détachement de composants de substrat d'après la revendication 9,
le chevauchement des substrats étant empêché.

11. Le système de détachement de composants de substrat d'après la revendication 9 ou 10,
dans le four de chauffage (17) du dispositif de chauffage de substrat, le substrat étant chauffé alors que le substrat est placé sur la plaque saillante (18) du convoyeur.

12. Le système de détachement de composants de substrat d'après l'une quelconque des revendications de 9 à 11,
sachant que la plaque saillante (18) peut être repliée sur la bande transporteuse (13) du convoyeur,
sachant que la plaque saillante (18) est dressée lorsque le substrat de montage (14) est placé sur la plaque saillante (18),
sachant que la plaque saillante (18) est repliée lorsque le substrat de montage (14) n'est pas placé sur la plaque saillante (18).
